# EUROPEAN PATENT APPLICATION

(11) **EP 3 425 681 A1**
(43) Date of publication of application: **09.01.2019**
(21) Application number: 18182058.0
(22) Date of filing: 05.07.2018
(51) Int. Cl.: H01L 31/048, H02S 20/10

(54) **ROAD SURFACE POWER GENERATION ASSEMBLY**

(30) Priority: 06.07.2017 CN 201720812955 U
(71) Applicant: Beijing Apollo Ding Rong Solar Technology Co., Ltd., Beijing 100176 (CN)
(72) Inventor: WANG, Yunfang, Beijing, Beijing 100176 (CN); DAI, Fengyu, Beijing, Beijing 100176 (CN); HUO, Yanyin, Beijing, Beijing 100176 (CN); CAO, Zhifeng, Beijing, Beijing 100176 (CN)
(74) Representative: Branca, Emanuela

(57) **Abstract**

A road surface power generation assembly is provided, which includes a substrate (1), a solar cell chip (2) and a glass layer (4, 5). The glass layer includes an upper glass layer (4) and a lower glass layer (5) which are secured through a sheet adhesive layer (3). The solar cell chip (2) is arranged between the lower glass layer (5) and the substrate (1). In the road surface power generation assembly, the glass layer is arranged to effectively protect the solar cell chip, thereby improving the tolerance of a road surface on which the road surface power generation assembly is arranged. The provided double layer glass can be bonded through hot pressing, to effectively prevent from breaking and falling off, thereby improving the security. In addition, the double layer glass are connected through the sheet adhesive layer, which achieves a soft connection, thereby improving toughness of the glass, and improving a cushioning effect.

## Description

### FIELD

The present disclosure relates to solar power generation technology, and in particular to a road surface power generation assembly having double layer glass.

### BACKGROUND

With the continuous development of new energy technologies, distributed solar energy can provide people with a more convenient energy supply. A plane or three-dimensional space is required in the distributed solar power generation as a site carrier.

At present, a large number of supporting electrical facilities which are used for lighting, monitoring and instructing are used in the transportation field, which results in a large demand for electricity. In solar power generation applied to the transportation field, in addition to roofs for service facilities, there are many spatial positions which can be applied to the solar power generation. Non-motor vehicle lanes for example in parks and pedestrian zones occupy a large area, and road surfaces of the non-motor vehicle lanes may be used for solar power generation. Solar cell chips are arranged on the road surfaces, as an integrated carrier for the landscape infrastructures and the facilities which are used for lighting, monitoring, and instructing.

However, since the road surface on which the solar cell chips are arranged is often stamped and collided, which results in poor wear resistance of the road surface, and affects a light absorption rate of the solar cell chip after long time use.

### SUMMARY

A road surface power generation assembly having double layer glass is provided in the present disclosure, to solve the problems in the conventional technology and improve the tolerance of a road surface on which the road surface power generation assembly is arranged.

A road surface power generation assembly is provided in the present disclosure. The road surface power generation assembly includes a substrate, a solar cell chip and a glass layer. The glass layer includes an upper glass layer and a lower glass layer which are secured through a sheet adhesive layer. The solar cell chip is arranged between the lower glass layer and the substrate.

In an embodiment, in the road surface power generation assembly described above, the solar cell chip is arranged on the substrate, and is arranged on a side of the substrate facing toward the lower glass layer.

In an embodiment, in the road surface power generation assembly described above, the solar cell chip is arranged on the lower glass layer, and is arranged on a side of the lower glass layer facing towards the substrate.

In an embodiment, in the road surface power generation assembly described above, a closed cavity is arranged between the substrate and the glass layer, and the cavity is filled with inert gas.

In an embodiment, in the road surface power generation assembly described above, sealant is provided at an edge of an area between the substrate and the lower glass layer, and structural adhesive sealant is provided at an edge of an area between the substrate and the upper glass layer.

In an embodiment, in the road surface power generation assembly described above, a light strip is arranged between the lower glass layer and the structural adhesive sealant.

In an embodiment, in the road surface power generation assembly described above, an anti-slip layer is arranged on an upper surface of the upper glass layer, and a hardened coating is arranged on the anti-slip layer.

In an embodiment, in the road surface power generation assembly described above, the sheet adhesive layer is made of ethylene-vinyl acetate copolymer (EVA), polyvinyl butyral (PVB), polyolefin elastomer (POE) or thermoplastic polyolefin (TPO).

In an embodiment, in the road surface power generation assembly described above, a thickness of each of the upper glass layer and the lower glass layer ranges from 3mm to 15mm, a thickness of the sheet adhesive layer ranges from 0.1mm to 2mm, and a height of the cavity ranges from 8mm to 20mm.

In an embodiment, in the road surface power generation assembly described above, the thicknesses of each of the upper glass layer and the lower glass layer is 10mm, and the height of the cavity is 12.5mm.

In the road surface power generation assembly provided in the present disclosure, the glass layer is arranged to effectively protect the solar cell chip, thereby improving the tolerance of a road surface on which the road surface power generation assembly is arranged. The provided double layer glass can be bonded through hot pressing, to effectively prevent from breaking and falling off, thereby improving the security. In addition, the double layer glass are connected through the sheet adhesive layer, which achieves a soft connection, thereby improving toughness of the glass, and improving a cushioning effect.

### BRIEF DESCRIPTION OF THE DRAWINGS

Figure 1 is a schematic structural diagram of a road surface power generation assembly having double layer glass according to an embodiment of the present disclosure; and
Figure 2 is an enlarged view of a part A in Figure 1.

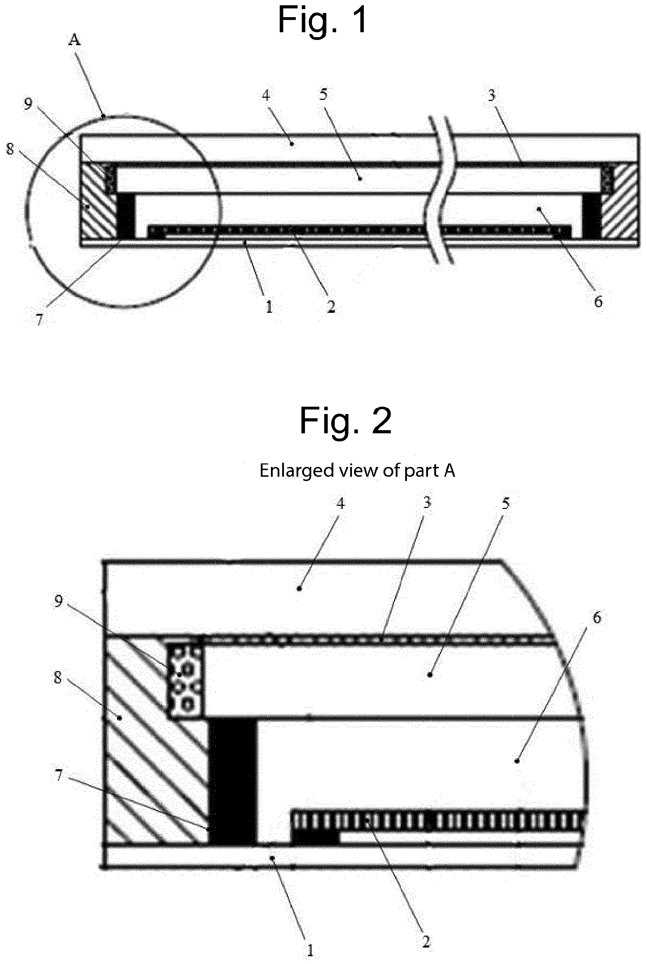

Reference Numerals in Figure 1 and Figure 2:

| | | | |
|---|---|---|---|
| 1 | substrate, | 2 | solar cell chip, |
| 3 | sheet adhesive layer, | 4 | upper glass layer, |
| 5 | lower glass layer, | 6 | cavity, |
| 7 | sealant, | 8 | structural adhesive sealant, |
| 9 | light strip. | | |

### DETAILED DESCRIPTION

The embodiments of the present disclosure are described below in detail. Examples of the embodiments are shown in the drawings. The same or similar reference numerals denote the same or similar elements or elements having the same or similar functions throughout the drawings. The embodiments described below with reference to the drawings are exemplary, and are only used to explain the present disclosure, and cannot be construed as a limit for the present disclosure.

Figure 1 is a schematic structural diagram of a road surface power generation assembly having double layer glass according to an embodiment of the present disclosure. The road surface power generation assembly according to the embodiment of the present disclosure includes a substrate 1, a solar cell chip 2 and a glass layer.

The glass layer includes an upper glass layer 4 and a lower glass layer 5. The upper glass layer 4 and the lower glass layer 5 are secured through a sheet adhesive layer 3. The solar cell chip 2 is arranged between the lower glass layer 5 and the substrate 1. The sheet adhesive layer 3 may be made of ethylene-vinyl acetate copolymer (EVA), polyvinyl butyral (PVB), polyolefin elastomer (POE) or thermoplastic polyolefin (TPO). In order to meet a strength requirement, the thickness of each of the upper glass layer 4 and the lower glass layer 5 ranges from 3mm to 15mm, and the thickness is preferably 10mm. The thickness of the sheet adhesive layer ranges from 0.1mm to 2mm.

In the road surface power generation assembly according to the embodiment of the present disclosure, the glass layer is provided to effectively protect the solar cell chip, thereby improving tolerance of a road surface on which the road surface power generation assembly is arranged. The provided double layer glass can be bonded through hot pressing, to effectively prevent from breaking and falling off, thereby improving the security. In addition, the double layer glass are connected through the sheet adhesive layer, which achieves a soft connection, thereby improving toughness of the glass, and improving a cushioning effect.

The road surface power generation assembly according to the embodiment of the present disclosure is installed on a road surface. The substrate 1 is arranged on the road surface, and the solar cell chip 2 is arranged between the substrate 1 and the lower glass layer 5. In an embodiment, the solar cell chip 2 may be arranged on the substrate 1, and is arranged on a side of the substrate 1 facing towards the lower glass layer 5. Alternatively, the solar cell chip 2 may be arranged on the lower glass layer 5, and is arranged on a side of the lower glass layer 5 facing towards the substrate 1. The solar cell chip 2 may be attached and fixed to the substrate 1 or the lower glass layer 5 through butyl sealant or in other manners.

In order to prevent the solar cell chip 2 from being damaged due to a pressure of the glass layer on the solar cell chip 2, a closed cavity 6 is arranged between the substrate 1 and the glass layer in an embodiment. Further, the cavity 6 is filled with inert gas. The inert gas is provided to prevent water vapor from entering the cavity 6, and thus prevent performance of the solar cell chip 2 from being affected by the water vapor. In this embodiment, the height of the cavity 6 ranges from 8mm to 20mm, and the height of the cavity 6 is preferably 12.5mm.

The above closed cavity 6 may be formed in the following manner. As shown in Figure 1 and Figure 2, sealant 7 is provided at an edge of an area between the substrate 1 and the lower glass layer 5, and structural adhesive sealant 8 is provided at an edge of an area between the substrate 1 and the upper glass layer 4. The sealant 7 may be butyl sealant, and the structural adhesive sealant 8 may be silicone structural adhesive sealant 8.

In order to improve a nighttime display effect of the road surface power generation assembly, a light strip 9 may be arranged between the lower glass layer 5 and the structural adhesive sealant 8.

Further, an anti-slip layer is arranged on an upper surface of the upper glass layer 4, and the anti-slip layer is formed through acid etching. A hardened coating is arranged on the anti-slip layer, to raise abrasion hardness of the upper glass layer 4.

Structure, characteristics and effects of the present disclosure are described above in detail based on the embodiments shown in the drawings. The embodiments described above are only preferred embodiments of the present disclosure. The present disclosure is not limited to the scope of implementation as shown by the drawings. Any changes, equivalents and modifications made to the embodiments based on the essence of the present disclosure without departing from the spirit of the specification and the drawings should fall within the protection scope of the present disclosure.

## Claims

1. A road surface power generation assembly, comprising:
a substrate;
a solar cell chip; and
a glass layer,
wherein the glass layer comprises an upper glass layer and a lower glass layer which are secured through a sheet adhesive layer, and
the solar cell chip is arranged between the lower glass layer and the substrate.

2. The road surface power generation assembly according to claim 1, wherein the solar cell chip is arranged on the substrate, and is arranged on a side of the substrate facing towards the lower glass layer.

3. The road surface power generation assembly according to claim 1, wherein the solar cell chip is arranged on the lower glass layer, and is arranged on a side of the lower glass layer facing towards the substrate.

4. The road surface power generation assembly according to claim 1, wherein a closed cavity is arranged between the substrate and the glass layer, and the closed cavity is filled with inert gas.

5. The road surface power generation assembly according to claim 4, wherein sealant is provided at an edge of an area between the substrate and the lower glass layer, and structural adhesive sealant is provided at an edge of an area between the substrate and the upper glass layer.

6. The road surface power generation assembly according to claim 5, wherein a light strip is arranged between the lower glass layer and the structural adhesive sealant.

7. The road surface power generation assembly according to claim 1, wherein an anti-slip layer is arranged on an upper surface of the upper glass layer, and a hardened coating is arranged on the anti-slip layer.

8. The road surface power generation assembly according to claim 7, wherein the anti-slip layer is formed through acid etching.

9. The road surface power generation assembly according to any one of claims 1 to 7, wherein the sheet adhesive layer is made of ethylene-vinyl acetate copolymer (EVA), polyvinyl butyral (PVB), polyolefin elastomer (POE) or thermoplastic polyolefin (TPO).

10. The road surface power generation assembly according to any one of claims 1 to 7, wherein
a thickness of each of the upper glass layer and the lower glass layer ranges from 3mm to 15mm;
a thickness of the sheet adhesive layer ranges from 0.1mm to 2mm; and
a height of the closed cavity ranges from 8mm to 20mm.

11. The road surface power generation assembly according to claim 10, wherein the thicknesses of each of the upper glass layer and the lower glass layer is 10mm, and the height of the closed cavity is 12.5mm.
